(19) Europäisches Patentamt
European Patent Office
Office européen des brevets

(11) **EP 3 173 856 A1**

(12) **EUROPEAN PATENT APPLICATION**

(43) Date of publication:
**31.05.2017 Bulletin 2017/22**

(51) Int Cl.:
**G02F 1/1333** (2006.01)   **B32B 27/08** (2006.01)
**G02B 1/14** (2015.01)

(21) Application number: **16186119.0**

(22) Date of filing: **29.08.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **30.11.2015   KR 20150168994**

(71) Applicant: **Samsung Display Co., Ltd.**
**Gyeonggi-Do (KR)**

(72) Inventors:
• **Heo, Jinnyoung**
  **Asan-si, Chungcheongnam-do (KR)**
• **An, Sungguk**
  **Yeongtong-gu, Suwon-si, Gyeonggi-do (KR)**
• **Ko, Hyunseok**
  **Gwangju (KR)**
• **Seo, Hyemin**
  **Asan-si, Chungcheongnam-do (KR)**
• **You, Sookkyung**
  **Seoul (KR)**
• **Dongjin, Jeong**
  **Seoul (KR)**

(74) Representative: **Gulde & Partner**
**Patent- und Rechtsanwaltskanzlei mbB**
**Wallstraße 58/59**
**10179 Berlin (DE)**

(54) **COVER WINDOW, DISPLAY DEVICE INCLUDING THE SAME, AND METHOD OF MANUFACTURING THE COVER WINDOW**

(57)     A cover window (CW-1) includes a plastic substrate (SUB), a first hard coating layer (HC-1) on a first surface of the plastic substrate (SUB), the first hard coating layer (HC-1) including a first organic-inorganic composite layer (IL-1) on the first surface, and a first organic layer (OL-1) between the first surface and the first organic-inorganic composite layer (IL-1), a second hard coating layer (HC-2) on a second surface of the plastic substrate (SUB) opposite to the first surface, the second hard coating layer (HC-2) including a second organic-inorganic composite layer (IL-2) on the second surface, and a second organic layer (OL-2) between the second surface and the second organic-inorganic composite layer (IL-2), and a functional layer (AFL) on the first hard coating layer (HC-1) with an optional intervening primer layer (PL).

FIG. 5

**Description**

**CROSS-REFERENCE TO RELATED APPLICATIONS**

This patent application claims priority to, and the benefit of, Korean Patent Application No. 10-2015-0168994, filed on November 30, 2015.

**BACKGROUND**

**1. Field**

One or more aspects of embodiments of the present disclosure herein relate to cover windows including a hard coating layer, methods of manufacturing the same, and display devices including a plastic cover window.

**2. Description of the Related Art**

Various types of display devices are used to provide image information. For example, liquid crystal displays (LCDs), plasma display panels (PDPs), organic light-emitting displays (OLEDs), field effect displays (FEDs), and electrophoretic display devices are used.

These display devices include a display module configured to display an image, and include a cover window configured to protect the display module. The cover window constitutes an outer surface of the display device, and may also provide a touch surface at the same time.

Recently, there has been research and development with respect to a cover window that is manufactured by using a plastic material. However, with respect to a display device having a touch screen function, a pointed tool, such as finger or pen, is frequently in contact with a surface of the cover window, and accordingly, scratches may occur on the surface of the cover window.

SUMMARY

The present disclosure describes a high strength cover window having improved scratch resistance and a display device including the same.

The present disclosure also describes a method of manufacturing a cover window having improved scratch resistance.

An embodiment of the inventive concept provides a cover window including a plastic substrate, a first hard coating layer on a first surface of the plastic substrate, the first hard coating layer including a first organic-inorganic composite layer on the first surface, and a first organic layer between the first surface and the first organic-inorganic composite layer, a second hard coating layer on a second surface of the plastic substrate opposite to the first surface, the second hard coating layer including a second organic-inorganic composite layer on the second surface, and a second organic layer between the second surface and the second organic-inorganic composite layer, and a functional layer on the first hard coating layer.

The first organic layer and the second organic layer may include urethane acrylate.

The first organic-inorganic composite layer and the second organic-inorganic composite layer may include an acrylate-based compound, inorganic particles dispersed in the acrylate-based compound, and polydimethylsiloxane.

The inorganic particles may include at least one selected of silicon oxide, zirconium oxide, aluminum oxide, tantalum oxide, niobium oxide, or glass beads.

The functional layer may include perfluoropolyether.

The cover window may further include a primer layer between the first organic-inorganic composite layer and the functional layer.

The primer layer may include a silane coupling agent and isocyanate.

A thickness of the first organic layer or the second organic layer may be in a range of about 10 $\mu$m to about 20 $\mu$m.

A thickness of the first organic-inorganic composite layer or the second organic-inorganic composite layer may be in a range of about 10 $\mu$m to about 20 $\mu$m.

The plastic substrate may include a flat portion, and at least one curved surface portion bent from edges of the flat portion.

An embodiment of the inventive concept provides a display device including a display module, a housing accommodating the display module, and a cover window on the display module, the cover window including a plastic substrate, a first hard coating layer on a first surface of the plastic substrate, the first hard coating layer including a first organic-inorganic composite layer on the first surface, and a first organic layer between the first surface and the first organic-inorganic composite layer, a second hard coating layer on a second surface of the plastic substrate opposite to the first surface, the second hard coating layer including a second organic-inorganic composite layer on the second surface, and a second organic layer between the second surface and the second organic-inorganic composite layer, and a functional layer on the first hard coating layer.

The first organic layer and the second organic layer may include urethane acrylate.

The first organic-inorganic composite layer and the second organic-inorganic composite layer may include an acrylate-based compound, inorganic particles dispersed in the acrylate-based compound, and polydimethylsiloxane.

The display device may further include a primer layer between the first organic-inorganic composite layer and the functional layer.

The display device may further include an adhesive member between the display module and the cover window.

The display module may include a flat area, and at least one curved surface area bent from edges of the flat area, and the plastic substrate may include a flat portion corresponding to the flat area of the display module, and at least one curved surface portion corresponding to the at least one curved surface area.

An embodiment of the inventive concept provides a method of manufacturing a cover window, the method including forming a first organic layer on a first surface of a plastic substrate, forming a second organic layer on a second surface of the plastic substrate opposite to the first surface, forming a first organic-inorganic composite layer on the first organic layer, forming a second organic-inorganic composite layer on the second organic layer, and forming a functional layer on the first organic-inorganic composite layer.

The method may further include forming a primer layer on the first organic-inorganic composite layer.

The first organic layer and the second organic layer may include urethane acrylate.

The first organic-inorganic composite layer and the second organic-inorganic composite layer may include an acrylate-based compound, inorganic particles dispersed in the acrylate-based compound, and polydimethylsiloxane.

The forming of the first organic layer and the forming of the second organic layer may be performed during a same process.

The forming of the first organic layer and the forming of the second organic layer may include providing a first coating composition to the plastic substrate, performing a heat treatment on the first coating composition, and ultraviolet curing the first coating composition.

The providing of the first coating composition to the plastic substrate may include a dip coating method.

The forming of the first organic-inorganic composite layer and the forming of the second organic-inorganic composite layer may be performed during a same process.

The forming of the first organic-inorganic composite layer and the forming of the second organic-inorganic composite layer may include providing a second coating composition on the first organic layer and the second organic layer, performing a heat treatment on the second coating composition, and ultraviolet curing the second coating composition.

The second coating composition may include an acrylate-based compound, inorganic particles, and polydimethylsiloxane, and a weight ratio of the acrylate-based compound to the inorganic particles may be in a range of about 5:5 to about 8:2.

The polydimethylsiloxane may include an amount of about 0.2 wt% to about 0.6 wt% based on a total weight of the acrylate-based compound and the inorganic particles.

The forming of the functional layer may include providing a functional coating composition on the first organic-inorganic composite layer, and thermal curing the functional coating composition.

BRIEF DESCRIPTION OF THE DRAWINGS

The accompanying drawings are included to provide a further understanding of the inventive concept, and are incorporated in, and constitute a part of, this specification. The drawings illustrate exemplary embodiments of the inventive concept and, together with the description, serve to explain aspects of the inventive concept. In the drawings:

FIG. 1 is a perspective view illustrating a display device according to an embodiment of the inventive concept;
FIG. 2 is a cross-sectional view of the display device taken along the line I-I' of FIG. 1;
FIG. 3 is an exploded perspective view of the display device illustrated in FIG. 1;
FIG. 4 is a cross-sectional view illustrating a display module according to an embodiment of the inventive concept;
FIGS. 5 and 6 are cross-sectional views illustrating cover windows according to one or more embodiments of the inventive concept;
FIG. 7 is a flowchart illustrating a method of manufacturing a cover window according to an embodiment of the inventive concept;
FIG. 8A schematically illustrates a cross-section of an organic-inorganic composite layer according to an embodiment of the inventive concept;

FIG. 8B is an image of the cross-section of the organic-inorganic composite layer according to the embodiment of the inventive concept; and

FIGS. 9 through 12 are graphs illustrating evaluation results of scratch resistance of the cover window according to one or more embodiments of the inventive concept.

DETAILED DESCRIPTION

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element, layer, region, or component is referred to as being "on," "connected to," or "coupled to" another element, layer, region, or component, it can be directly on, connected to, or coupled to the other element, layer, region, or component, or one or more intervening elements, layers, regions, or components may be present. In addition, it will also be understood that when an element or layer is referred to as being "between" two elements or layers, it can be the only element or layer between the two elements or layers, or one or more intervening elements or layers may also be present.

In the following examples, the x-axis, the $\gamma$-axis and the z-axis are not limited to three axes of a rectangular coordinate system, and may be interpreted in a broader sense. For example, the x-axis, the $\gamma$-axis, and the z-axis may be perpendicular to one another, or may represent different directions that are not perpendicular to one another.

The terminology used herein is for the purpose of describing particular embodiments only and is not intended to be limiting of the present invention. As used herein, the singular forms "a," "an," and "the" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, the use of "may" when describing embodiments of the present invention refers to "one or more embodiments of the present invention." As used herein, the terms "use," "using," and "used" may be considered synonymous with the terms "utilize," "utilizing," and "utilized," respectively. Also, the term "exemplary" is intended to refer to an example or illustration.

When a certain embodiment may be implemented differently, a specific process order may be performed differently from the described order. For example, two consecutively described processes may be performed substantially at the same time or performed in an order opposite to the described order.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

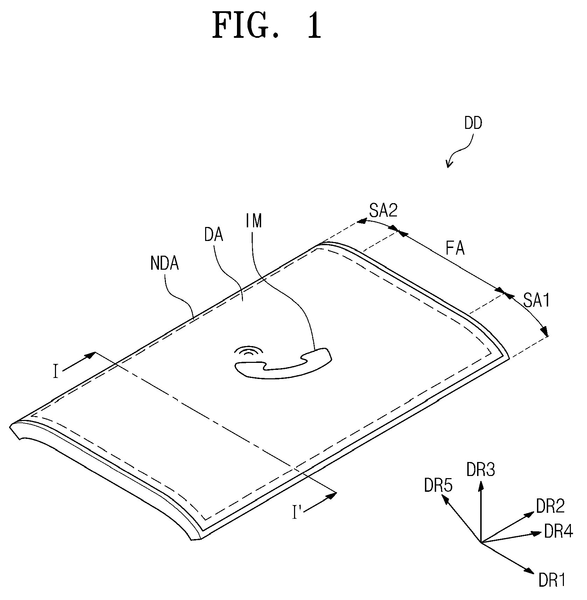

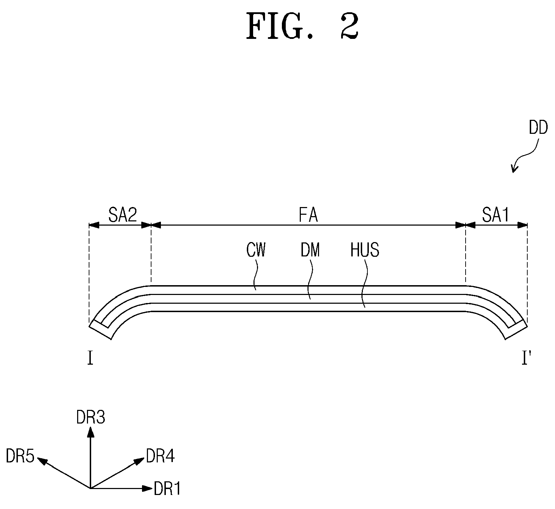

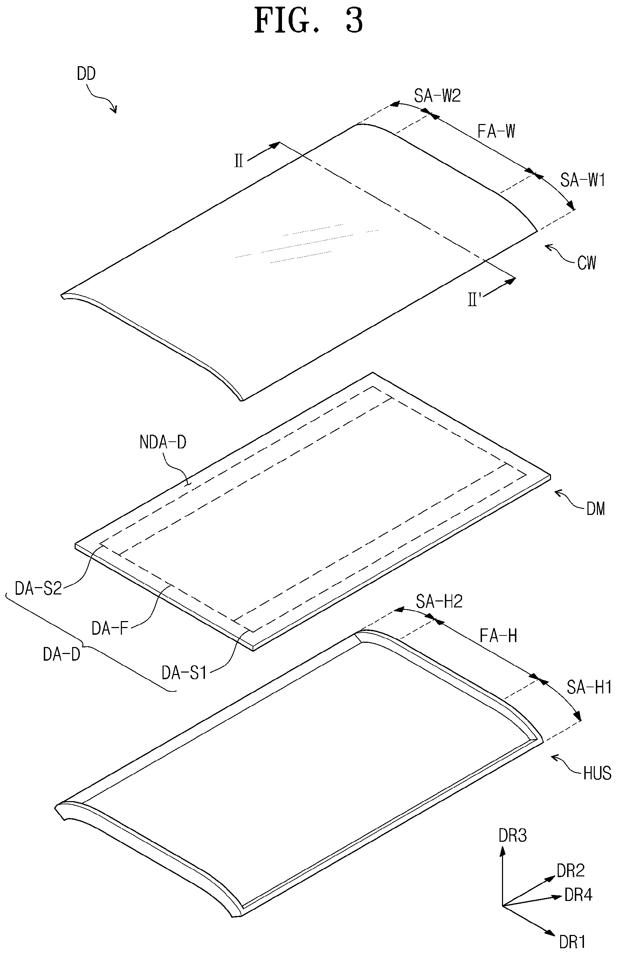

FIG. 1 is a perspective view illustrating a display device DD according to an embodiment of the inventive concept, FIG. 2 is a cross-sectional view of the display device DD taken along the line I-I' of FIG. 1, and FIG. 3 is an exploded perspective view of the display device DD illustrated in FIG. 1.

In FIG. 1, the display device DD, which may be applied to a smartphone, is illustrated according to an embodiment of the inventive concept. However, the inventive concept is not limited thereto, and the display device DD according to other embodiments of the inventive concept may be applied to electronic devices, such as a television, a personal computer, a notebook computer, a car navigation unit, a game console, a sound electronic device, a wearable device, and a camera. Also, the listed electronic devices are merely presented as examples, the display device DD may be used in other electronic devices.

As illustrated in FIG. 1, the display device DD includes a display area DA (or display part) on which an image IM may be displayed, and includes a non-display area NDA (or non-display part) on which an image is not displayed. In the present embodiment, the expression "display area DA and non-display area NDA" defines the display device DD as a plurality of areas (or parts) that are divided according to whether the areas are configured to display an image or not. Although the non-display area NDA surrounding the display area DA has been exemplarily illustrated in FIG. 1, the inventive concept is not limited thereto, and the non-display area NDA may instead be on one side of the display area DA. Also, the non-display area NDA may be omitted.

Referring to FIG. 1, the display device DD includes a flat area FA having a flat display area, and includes at least one curved surface area (e.g., SA1 and SA2), which may be bent from edges of the flat area. In the present embodiment, the expression "flat area FA and curved surface area SA1/SA2" defines the display device DD as a plurality of areas (or parts) that are divided or defined according to their shape.

The flat area FA in the display device, for example, may correspond to a portion of a smartphone in which a main image IM is displayed on a front surface. Also, the curved surface area SA1 and/or SA2 may correspond to a portion in which a main image and/or a sub-image(s) is displayed on a side surface.

In the present embodiment, the display device DD including two curved surface areas SA1 and SA2 at both sides of edge portions of the flat area FA is exemplarily illustrated. However, the display device DD is not limited thereto, and the display device DD may instead include only a flat area FA, or may include a flat area FA and a single curved surface area bent from one side of the flat area FA.

The flat area FA of the display device is parallel to a surface, or plane, defined by a first directional axis DR1 and a second directional axis DR2. A third directional axis DR3 indicates a normal direction that is normal to the flat surface FA. In the drawings, the third directional axis DR3 corresponds to a reference axis that distinguishes between a front surface and a rear surface of each member. The first curved surface area SA1 bent from the one side of the flat area FA may correspond to an area in which an image is displayed in, or with respect to, a fourth directional axis DR4, which crosses the first directional axis DR1, the second directional axis DR2, and the third directional axis DR3. Also, the second curved surface area SA2 that is bent form another side of the flat area FA may correspond to an area in which an image is displayed in, or with respect to, a fifth directional axis DR5. In this case, the fourth directional axis DR4 and the fifth directional axis DR5 may be symmetrical relative to the third directional axis DR3. However, directions indicated by the above-described first to fifth directional axes DR1 to DR5 for describing the display area DA are a relative concept, and may be changed to other directions in other embodiments.

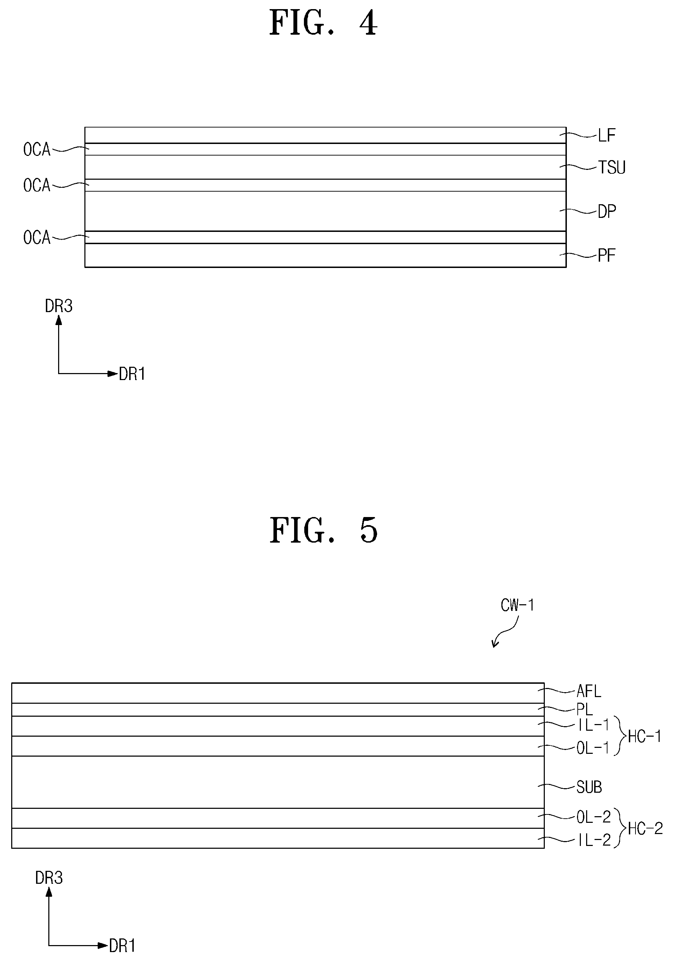

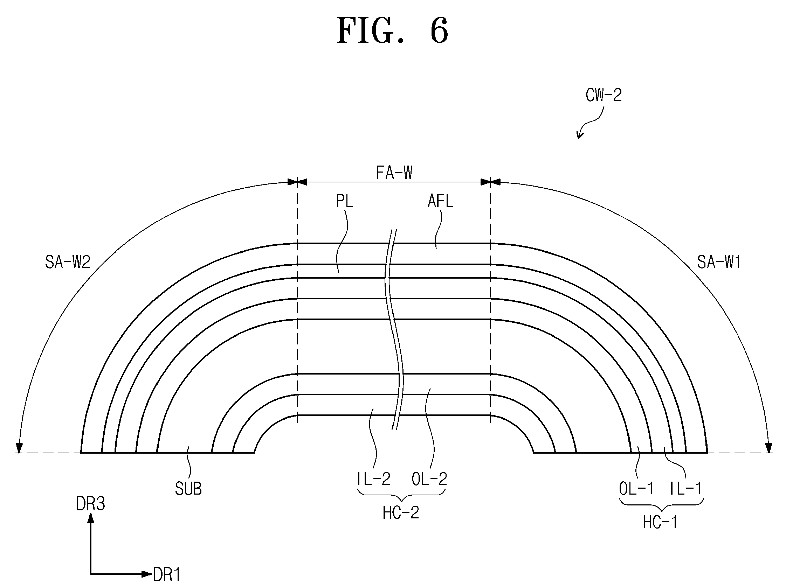

Referring to FIG. 2, the display device DD may include a cover window CW, a display module DM, and a housing HUS. The cover window CW may be at a front surface of the display device DD. The cover window CW may provide input surface/touch surface/display surface for a user's information input in the display device DD. The cover window CW may be provided by including a plastic substrate, a first hard coating layer, a second hard coating layer, and a functional layer. The cover window CW will be described in detail later with respect to FIGS. 5 and 6.

The display module DM generates an image, and may provide the generated image to the front surface on which the cover window CW is located. The display module DM may be accommodated in the housing HUS.

Although the display module DM and the cover window CW are accommodated in the housing HUS in the present embodiment, the inventive concept is not limited thereto. For example, the housing HUS may accommodate the display module DM, and the cover window CW may be on the housing HUS while covering the front surface of the display module DM. Also, an optically transparent adhesive member may be between the cover window CW and the display module DM, or may be between the display module DM and the housing HUS.

In the display device of the present embodiment, the first curved surface area SA1 may display an image in the fourth directional axis DR4, and the second curved surface area SA2 may display an image in the fifth directional axis DR5.

Referring to FIG. 3, the cover window CW may include a flat portion FA-W, and curved surface portions SA-W1 and SA-W2, which respectively correspond to the flat area FA and the curved surface areas SA1 and SA2 of the display device DD. That is, in the embodiment shown in FIG. 3, the cover window CW may have a bent shape that includes the flat portion FA-W and the curved surface portions SA-W1 and SA-W2. Also, the cover window CW according to the present embodiment may have a flat shape including only a flat portion FA-W, or may have a shape including a flat portion FA-W and a single curved surface portion on one side thereof.

The display module DM of the present embodiment includes a display area DA-D and a non-display area NDA-D, which may respectfully define, or correspond to, the display area and the non-display area of the display device DD. The display area DA-D may include a flat display area DA-F, a first side display area DA-S1, and a second side display area DA-S2, which respectively correspond to the flat area FA, the first curved surface area SA1, and the second curved surface area SA2 of the display device DD of FIG. 2.

As illustrated in FIG. 3, the display module DM, prior to being coupled to the cover window CW, may be a flat member. The display module DM may have flexible properties, and may have a shape that is modified according to the form in which it is accommodated in the housing HUS, or the form in which it is coupled to the cover window CW. As a result of being coupled to the cover window CW, the display module DM may be divided into the flat area DA-F and the side areas DA-S1 and DA-S2. Pixels may be in the display area DA-D, and pixels may be omitted from the non-display area NDA-D. Although the non-display area NDA-D surrounding the display area DA-D has been exemplarily illustrated, the non-display area NDA-D of other embodiments may instead be on only a single side of the display area DA-D.

The housing HUS may include a flat area FA-H, a first side area SA-H1, and a second side area SA-H2, which respectively correspond to the flat area FA, the first curved surface area SA1, and the second curved surface area SA2 of the display device DD. In an embodiment of the inventive concept, the housing HUS may have an overall flat shape. Although the integrated housing HUS has been exemplarily illustrated in FIG. 3, the housing HUS may include a plurality of parts that are coupled to each other. Also, in an embodiment of the inventive concept, the housing HUS may be omitted, and may be substituted with a plurality of brackets.

FIG. 4 is a cross-sectional view illustrating a display module according to an embodiment of the inventive concept. The display module includes a display panel DP and functional members. The display panel DP is a flexible display panel and, for example, may be an organic light-emitting diode display panel, an electronic ink display panel, an electrowetting display panel, or an electrophoretic display panel.

The functional members may include at least one of a protective film PF, a touch sensing unit TSU, and an optical member LF. However, the inventive concept is not limited thereto, and the display module may further include additional functional members in addition to the listed members. Each of the functional members may have flexible properties. The protective film PF may protect the display panel DP from an external impact. The optical member LF may include a polarizer or an optical retarder. The type of the touch sensing unit TSU is not limited, and the touch sensing unit TSU may be a capacitive type touch sensing unit, or may be an electromagnetic induction type touch sensing unit.

The display panel DP, protective film PF, touch sensing unit TSU, and optical member LF may be bonded by using an optically transparent adhesive member OCA (e.g., by using a plurality of optically transparent adhesive members OCA). Also, the inventive concept is not limited thereto, and any one among the functional members may be directly formed on an adjacent functional member among the functional members. For example, one surface of any one of the display panel DP and the touch sensing unit TSU may be coated with the polarizer, and electrodes and interconnections of the touch sensing unit TSU may be integrated with the display panel DP.

FIGS. 5 and 6 are cross-sectional views illustrating cover windows according to an embodiment of the inventive concept. FIG. 5 may be the cross-sectional view of the cover window including only a flat portion, and FIG. 6 may be the cross-sectional view of the cover window including a flat portion FA-W and curved surface portions SA-W1 and SA-W2. For example, the cover window of FIG. 6 may be a cross-sectional view taken along the line II-II' in FIG. 3.

The cover windows of FIGS. 5 and 6 may include a plastic substrate SUB, a first hard coating layer HC-1 on a first surface of the plastic substrate SUB, and a second hard coating layer HC-2 on a second surface of the plastic substrate SUB. For example, the first surface of the plastic substrate SUB, as a top surface of the plastic substrate SUB, may correspond to a surface on which an image may be provided in the display device. The second surface of the plastic substrate SUB may be a bottom surface of the plastic substrate SUB.

The plastic substrate SUB may be formed of a polymer material. For example, the plastic substrate SUB may be formed of polyimide, polyacrylate, polymethylmethacrylate (PMMA), polycarbonate (PC), polyethylene naphthalate (PEN), polyvinylidene chloride (PVC), polyvinylidene difluoride (PVDF), polystyrene, an ethylene vinyl alcohol copolymer, and/or a combination thereof. However, a material of the plastic substrate SUB used in the embodiment of the inventive concept is not limited to the listed polymer materials, and any material may be used without limitation so long as it has an optical transparency capable of providing an image provided from the display module of the display device to a user.

For example, polycarbonate PC may be used as the plastic substrate SUB of the cover window CW, according to an embodiment of the inventive concept. The polycarbonate plastic substrate may have excellent transparency and may have high strength and surface hardness.

The cover window CW may include a hard coating layer HC-1/HC-2 on respective surfaces of the plastic substrate SUB. The first hard coating layer HC-1 on the first surface/top surface of the plastic substrate SUB may include a first organic layer OL-1 and a first organic-inorganic composite layer IL-1. The second hard coating layer HC-2 on the second surface/bottom surface of the plastic substrate SUB may include a second organic layer OL-2 and a second organic-inorganic composite layer IL-2.

In the first hard coating layer HC-1, the first organic-inorganic composite layer IL-1 is on the first surface of the plastic substrate SUB, and the first organic layer OL-1 is between the first surface of the plastic substrate SUB and the first organic-inorganic composite layer IL-1. Also, in the second hard coating layer HC-2, the second organic-inorganic composite layer IL-2 is on the second surface of the plastic substrate SUB, and the second organic layer OL-2 is between the second surface of the plastic substrate SUB and the second organic-inorganic composite layer IL-2.

That is, referring to FIGS. 5 and 6, in the cover window CW according to the present embodiment, the first hard coating layer HC-1 and the second hard coating layer HC-2 may be symmetrical to each other relative to the plastic substrate SUB. For example, the first hard coating layer HC-1 and the second hard coating layer HC-2 may be composed of the same material, and/or may have the same thickness. That is, the first organic layer OL-1 and the second organic layer OL-2 may be composed of the same material, and/or may be formed to have the same thickness. Also, the first organic-inorganic composite layer IL-1 and the second organic-inorganic composite layer IL-2 may be composed of the same material, and/or may be formed to have the same thickness.

In the present embodiment, because the symmetrical hard coating layers HC-1 and HC-2 are on respective surfaces relative to the plastic substrate SUB in the cover window CW, distortion of the cover window CW or a peeling-off phenomenon of the coating layer(s) HC-1/HC-2 in harsh conditions, such as high temperature and/or high humidity, may be reduced. Thus, reliability may be improved.

The first organic layer OL-1 and the second organic layer OL-2 are respectively adjacent the first surface and the second surface of the plastic substrate SUB. The first organic layer OL-1 and the second organic layer OL-2 may be formed of an acrylate-based compound. For example, the first organic layer OL-1 and the second organic layer OL-2 may include urethane acrylate. The first organic layer OL-1 or the second organic layer OL-2 may function as a stress buffer layer by being between the plastic substrate SUB and the first organic-inorganic composite layer IL-1, or between the plastic substrate SUB and the second organic-inorganic composite layer IL-2.

The first organic layer OL-1 or the second organic layer OL-2 may have a thickness of about 10 $\mu$m or more to about 20 $\mu$m or less. When the thickness of the first organic layer OL-1 and the second organic layer OL-2 is less than about 10 $\mu$m, an effect of improving the surface hardness might not be obtained. Also, when the thickness of the first organic layer OL-1 and the second organic layer OL-2 is greater than about 20 $\mu$m, because stress in the layer may be increased, and because elasticity may be reduced, the first organic layer OL-1 and the second organic layer OL-2 may be easily broken. Furthermore, with respect to optical properties, color of an image may change to yellowish as thickness of the organic layer increases. Specifically, the first organic layer OL-1 and the second organic layer OL-2 may have good surface hardness and good optical properties at a thickness of about 10 $\mu$m or more to about 15 $\mu$m or less.

The first organic-inorganic composite layer IL-1 is on the first organic layer OL-1. The second organic-inorganic composite layer IL-2 is on the second organic layer OL-2. The first organic-inorganic composite layer IL-1 and the second organic-inorganic composite layer IL-2 may be formed from a mixed coating composition in which an organic material and inorganic particles are blended. In this case, the organic material may include an acrylate-based compound, and the inorganic particles may include an inorganic oxide.

The organic material may be formed of at least one of an acrylate-based compound, a polyurethane-based compound, or an epoxy-based compound, and/or a combination thereof. For example, the first and second organic-inorganic composite layers IL-1 and IL-2 may include urethane acrylate.

The inorganic oxide included in the inorganic particles may be at least one selected from the group consisting of silicon oxide ($SiO_2$), zirconium oxide ($ZrO_2$), aluminum oxide ($Al_2O_3$), tantalum oxide ($Ta_2O_5$), niobium oxide ($Nb_2O_5$, $NbO_2$), and/or glass beads.

The inorganic particles may be provided in the form of a single inorganic oxide listed, or a mixture thereof. Also, the inorganic particles may be provided in various forms to form the organic-inorganic composite layer IL-1/IL-2. For example, the silicon oxide may be provided in the form of $SiO_2$ particles, a $SiO_2$ sol in which $SiO_2$ particles are dispersed in a colloidal state, or $SiO_2$ having a hollow shape.

In the first and second organic-inorganic composite layers IL-1 and IL-2, the acrylate compound, as the organic material, and the inorganic particles may be mixed in a weight ratio of about 5:5 to about 8:2. Because both of the acrylate compound and the inorganic particles are included, the first and second organic-inorganic composite layers IL-1 and IL-2 may provide shock absorption against external impact while improving the surface hardness. Thus, the first and second organic-inorganic composite layers IL-1 and IL-2 may constitute hard coating layers that are not easily broken.

Also, the first organic-inorganic composite layer IL-1 and the second organic-inorganic composite layer IL-2 may include polydimethylsiloxane (PDMS). For example, the first organic-inorganic composite layer IL-1 and the second organic-inorganic composite layer IL-2 may be formed by including urethane acrylate, $SiO_2$, and PDMS.

The polydimethylsiloxane (PDMS) may be dispersed in the organic-inorganic composite layer IL-1/IL-2, which may be configured by including the acrylate-based compound and the inorganic particles. Also, the PDMS may be mainly adjacent a surface layer (or skin layer) of the organic-inorganic composite layer IL-1/IL-2.

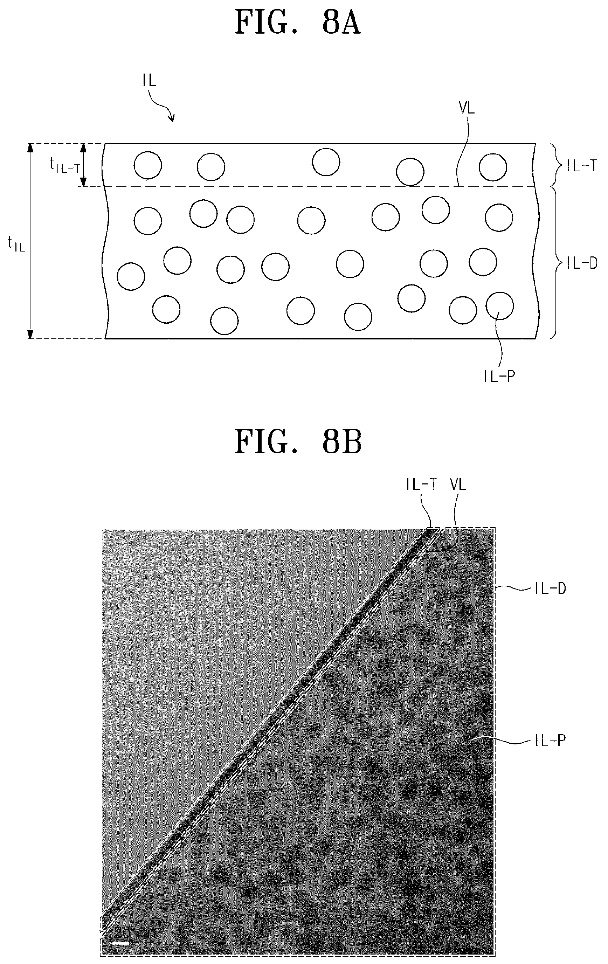

FIG. 8A schematically illustrates a portion of the organic-inorganic composite layer of the cover window, and FIG. 8B, as a cross-sectional image of the portion of the organic-inorganic composite layer of the cover window, illustrates a transmission electron microscope (TEM) image.

For example, FIGS. 8A and 8B may illustrate the first organic-inorganic composite layer. Polydimethylsiloxane may be mainly disposed in a surface portion IL-T of the organic-inorganic composite layer, which may be divided from a center portion IL-D by an imaginary dotted line VL in the organic-inorganic composite layer of FIGS. 8A and 8B. That is, the polydimethylsiloxane may be mainly disposed in the surface portion IL-T, as opposed to the center portion IL-D of the organic-inorganic composite layer IL. As illustrated in FIGS. 8A and 8B, because the polydimethylsiloxane is mainly located in the surface portion IL-T of the organic-inorganic composite layer IL, a friction coefficient of the hard coating layer may be reduced. Thus, slip, or smoothness, of the surface of the hard coating layer may be increased.

Referring to FIG. 8A, the polydimethylsiloxane may be mainly disposed in the surface portion IL-T of the organic-inorganic composite layer IL, and a thickness $t_{IL-T}$ of the surface portion IL-T in which the polydimethylsiloxane is mainly located may be in a range of about 20 nm to about 50 nm. The thickness $t_{IL-T}$ may correspond to a range of about 10% to about 20% of a total thickness $t_{IL-T}$ of the organic-inorganic composite layer IL.

In the organic-inorganic composite layer IL, inorganic particles IL-P may be dispersed in an entirety of the organic-inorganic composite layer IL. The inorganic particles IL-P may have a spherical shape, but the inventive concept is not limited thereto. An average diameter of the inorganic particles may be in a range of about 10 nm or more to about 50 nm or less. In the image of FIG. 8B, the average diameter of the inorganic particles may be about 20 nm.

The first organic-inorganic composite layer and the second organic-inorganic composite layer may have a thickness of about 10 μm or more to about 20 μm or less (inconsistent with the disclosure of par. [0093]. Please check). When the thickness of the first organic-inorganic composite layer and the second organic-inorganic composite layer is less than about 10 μm, the effect of improving the surface hardness may be insufficient. Also, when the first organic-inorganic composite layer and the second organic-inorganic composite layer are formed to a thickness that is greater than about 20 μm, elasticity may be reduced, and thus, the first organic-inorganic composite layer and the second organic-inorganic composite layer might be more easily broken. For example, when the organic-inorganic composite layer is formed to a thickness of greater than about 20 μm, brittleness may be increased, and thus, fracture stiffness in a ball drop test may be reduced. Furthermore, with respect to optical properties, when the thickness of the organic-inorganic composite layer increases, the color of the display may change to yellowish. Specifically, the first organic-inorganic composite layer and the second organic-inorganic composite layer may have good surface hardness and optical properties at a thickness of about 15 μm or more to about 20 μm or less.

In FIGS. 5 and 6, a functional layer AFL may be on the first hard coating layer HC-1. The functional layer AFL may include one or more of an anti-finger coating layer, an anti-fouling coating layer, an anti-reflection coating layer, an anti-glare coating layer, and a hard-coating layer. For example, in the cover window of the present embodiment, the functional layer AFL may be the anti-finger coating layer, and the functional layer AFL as the anti-finger coating layer may be formed by including perfluoropolyether.

The functional layer AFL may have a thickness of about 20 nm or more to about 50 nm or less. When the functional layer AFL is formed to a thickness of less than about 20 nm, scratch resistance may be reduced. Also, when the functional layer AFL is formed to a thickness of greater than about 50 nm, because a haze phenomenon may occur, the optical properties of the cover window may be deteriorated.

In the cover window according to the present embodiment illustrated in FIGS. 5 and 6, a primer layer PL may be further included between the first hard coating layer HC-1 and the functional layer AFL. The primer layer PL may be an adhesion auxiliary layer that increases a binding force between the functional layer AFL and the first hard coating layer HC-1.

In an embodiment of the inventive concept, the primer layer PL may include a silane coupling agent and isocyanate. For example, the primer layer PL may be located between the first organic-inorganic composite layer IL-1 of the first hard coating layer HC-1 including polydimethylsiloxane, and the functional layer AFL including perfluoropolyether, thereby improving bond strength between the functional layer AFL and the first organic-inorganic composite layer IL-1.

The primer layer PL may have a thickness of about 10 nm or more to about 30 nm or less. When the primer layer PL is formed to a thickness of less than about 10 nm, because the function of the primer layer PL as the adhesion auxiliary layer may be reduced, the binding force with the functional layer AFL may be reduced. Also, when the primer layer PL is formed to a thickness of greater than about 30 nm, because the haze phenomenon may occur, the optical properties may be deteriorated.

FIG. 6 includes a configuration of a cover window CW-1 of FIG. 5 as it is, but has a difference in the shape of the cover window. A cover window CW-2 of FIG. 6 may correspond to the cover window CW of the above-described display device illustrated in FIG. 3.

In FIG. 6, the cover window CW-2 includes the plastic substrate SUB, the first hard coating layer HC-1 on the first surface of the plastic substrate SUB, and the second hard coating layer HC-2 on the second surface of the plastic substrate SUB. The primer layer PL and the functional layer AFL are included on the first hard coating layer HC-1. Also, the first hard coating layer HC-1 and the second hard coating layer HC-2 respectively include the first organic layer OL-1 and first organic-inorganic composite layer IL-1, and the second organic layer OL-2 and second organic-inorganic composite layer IL-2.

Constituent materials and functions of each layer are the same as the configuration of the above-described cover window of FIG. 5, and, hereinafter, the difference in shape will only be described.

The cover window CW-2 of FIG. 6 includes the plastic substrate including a flat portion and curved surface portions. That is, in an embodiment of the inventive concept, the plastic substrate SUB may include the flat portion FA-W and at least one curved surface portion SA-W1 and SA-W2 bent from respective edges of the flat portion FA-W.

Also, the first hard coating layer HC-1 and the second hard coating layer HC-2 may have a uniform thickness along a shape of the plastic substrate SUB. The functional layer AFL and the primer layer PL may also be formed along the shape of the plastic substrate SUB.

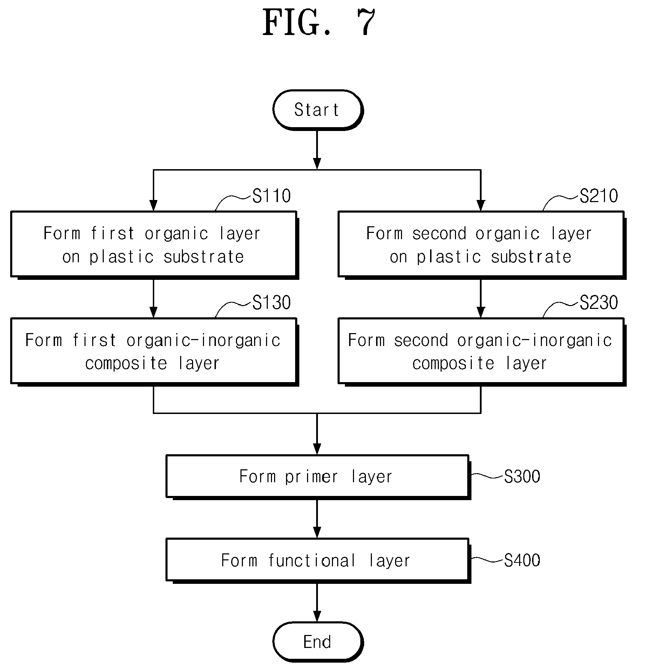

FIG. 7 is a flowchart illustrating a method of manufacturing a cover window according to an embodiment of the inventive concept. The method of manufacturing a cover window according to the present embodiment may include forming a first organic layer on a plastic substrate (S110), forming a second organic layer on the plastic substrate (S210), forming a first organic-inorganic composite layer (S130), forming a second organic-inorganic composite layer (S230), forming a primer layer (S300), and forming a functional layer (S400).

In an embodiment of the inventive concept, the forming of the primer layer (S300) may be omitted. In this case, the functional layer may be directly formed on the first organic-inorganic composite layer.

The first organic layer may be formed on a first surface of the plastic substrate, and the second organic layer may be formed on a second surface of the plastic substrate. The first surface and the second surface may respectively be a top surface and a bottom surface of the plastic substrate. The first organic-inorganic composite layer may be formed on the first organic layer. The second organic-inorganic composite layer may be formed on the second organic layer. Also, the primer layer may be formed on the first organic-inorganic composite layer, and the functional layer may be formed on the primer layer.

The forming of the first organic layer on the plastic substrate (S110) and the forming of the second organic layer on the plastic substrate (S210) may be performed at the same time, or during a same process. The forming of the first organic layer and second organic layer on the plastic substrate (S110 and S210) may include providing a first coating composition on the plastic substrate, performing a heat treatment on the first coating composition, and photocuring the first coating composition by irradiation with ultraviolet light after the heat treatment.

The first coating composition may be provided to both of the top surface and the bottom surface of the plastic substrate. The first coating composition may include an acrylate-based compound. The first coating composition may be an acrylate-based compound dissolved in an organic solvent. For example, the organic solvent may be a mixed organic solvent including methanol, methyl ethyl ketone (MEK), and isopropyl alcohol. The acrylate-based compound may include urethane acrylate. Also, the first coating composition may include a photoinitiator.

The first coating composition may be provided on the plastic substrate by using various coating methods. For example, the first coating composition may be provided on the plastic substrate by a dip coating method. The first coating composition may be simultaneously provided, or may be provided during the same process, on the top surface and the bottom surface of the plastic substrate using the dip coating method. Thereafter, the coated first coating composition may be heat-treated to volatilize the solvent. For example, the heat treatment may be performed at a temperature of about 60°C. Thereafter, the first organic layer and the second organic layer may be formed by curing the acrylate compound by irradiation with ultraviolet light.

The forming of the first organic-inorganic composite layer (S130) and the forming of the second organic-inorganic composite layer (S230) may be performed at the same time, or during the same process. The forming of the first organic-inorganic composite layer on the first organic layer (S130) and the forming of the second organic-inorganic composite layer on the second organic layer (S230) may include providing a second coating composition, performing a heat treatment on the second coating composition, and photocuring the second coating composition by irradiation with ultraviolet light after the heat treatment.

The second coating composition may include propylene glycol monomethyl ether acetate as a solvent, may include an organic material, i.e., an acrylate-based compound, and inorganic particles, as a solid content dissolved in the solvent, or may also include polydimethylsiloxane.

The solid content in the second coating composition may be included in an amount of about 60 wt% to about 70 wt% based on a total weight of the solvent. In the second coating composition, the acrylate-based compound and the inorganic particles may be mixed in a weight ratio of about 5:5 to about 8:2. For example, the second coating composition may include urethane acrylate and $SiO_2$ particles as the solid content, and the urethane acrylate and the $SiO_2$ particles may be included in a weight ratio of about 6:4.

Also, when a total weight of the acrylate-based compound and the inorganic particles in the second coating composition is defined as, or normalized to, 100, then the polydimethylsiloxane may be included in an amount of about 0.2 wt% to about 0.6 wt% based on the total weight of the acrylate-based compound and the inorganic particles.

Because the polydimethylsiloxane is included in the second coating composition, the friction coefficient of the hard coating layer may be reduced. Thus, slip, or smoothness, of the surface of the cover window may be increased. Accordingly, the scratch resistance of the cover window may be improved. However, when the polydimethylsiloxane is included in the second coating composition in an amount of less than about 0.2 wt%, an effect of improving the scratch resistance may not be obtained. Also, when the polydimethylsiloxane is included in an amount that is greater than about 0.6 wt%, adhesion of the functional layer formed on the hard coating layer may be reduced.

The inorganic particles may be inorganic oxide particles. The inorganic particles, for example, may be provided in the form of powder or a sol in which the inorganic particles are dispersed in a liquid medium.

The inorganic particles have a spherical shape, and may have substantially a monodisperse size distribution, or may have a polydisperse distribution that is obtained by mixing a plurality of particles having a monodisperse distribution. For example, an average diameter of the inorganic particles may be in a range of about 10 nm or more to about 50 nm or less. When the diameter of the inorganic particles is greater than about 50 nm, the inorganic particles might not be uniformly dispersed in the second coating composition. Also, when the diameter of the inorganic particles is less than about 10 nm, the effect of improving the surface hardness in the hard coating layer may be reduced. The second coating composition may allow the hard coating layer to have optical transparency while improving the surface hardness of the hard coating layer by including the inorganic particles having a diameter of about 10 nm or more to about 50 nm or less.

The second coating composition may be provided on the first and second organic layers by using various coating methods. For example, the second coating composition may be provided on the first and second organic layers by a dip coating method.

The second coating composition provided may form the first organic-inorganic composite layer and the second organic-inorganic composite layer through a heat treatment process and through an ultraviolet irradiation process. For example, the heat treatment process may be performed at a temperature of about 60°C. In the heat treatment process, the solvent of the second coating composition is volatilized, and the first organic-inorganic composite layer and the second organic-inorganic composite layer may then be formed by photocuring the acrylate compound by irradiation with ultraviolet light.

When the first organic-inorganic composite layer and the second organic-inorganic composite layer are formed, then the forming of the primer layer on the first organic-inorganic composite layer (S300) and the forming of the functional layer on the primer layer (S400) may be performed. Also, in the method of manufacturing a cover window according to other embodiments of the inventive concept, the forming of the primer layer on the first organic-inorganic composite layer (S300) may be omitted. In this case, the functional layer may be directly formed on the first organic-inorganic composite layer.

The primer layer may be formed on the first organic-inorganic composite layer, and may be formed by coating a primer material including a silane coupling agent and isocyanate. The primer layer may be provided by a wet coating method. A plasma pretreatment process may be further performed on the first hard coating layer before the forming of the primer layer. When the plasma pretreatment process is performed, bond strength of the primer layer to the first hard coating layer may be improved. The primer material provided by the wet coating method may form the primer layer through a thermal curing process.

The functional layer may be formed on the primer layer. Also, when the primer layer is not formed, the functional layer may be formed on the first organic-inorganic composite layer. The functional layer may be formed by a wet coating method. For example, the functional layer may be formed by a spray coating method.

The forming of the functional layer (S400) may include providing a functional coating composition, and may include thermal curing the functional coating composition. The functional coating composition may include perfluoropolyether.

For example, the functional coating composition may be provided on the primer layer by a spray coating method. Also, a plasma pretreatment process may be further performed on the primer layer before the providing of the functional coating composition. Because the plasma pretreatment process is further performed, adhesive strength between the primer layer and the functional layer may be improved.

The functional layer may be formed by thermal curing the functional coating composition, which may be provided by the spray coating method as a wet coating method. The thermal curing process may be performed at a temperature of about 60°C. As described above, because the functional layer is formed by the wet coating method, the thickness of the layer may be increased in comparison to a case in which the functional layer is formed by a dry method using an e-beam. Thus, because a relatively thick functional layer is formed by the wet coating method, protection of the hard coating layer formed under the functional layer may be improved. Also, because the primer layer and the functional layer are formed by the wet coating method, chemical bonding with the first hard coating layer may be formed. Thus, adhesive strength at an interface of each layer may be increased.

**Examples**

Hereinafter, a method of manufacturing a cover window having a stacked structure illustrated in FIG. 5 according to an embodiment of the inventive concept, and characteristics of the cover window provided by the manufacturing method according to an embodiment of the inventive concept, will be described in detail. However, the cover window and the method of manufacturing a cover window described in the following examples are merely exemplary, and the scope of the exemplary embodiments is not limited thereto.

**Manufacture of Cover Window**

An example of a first coating composition was provided to a polycarbonate plastic substrate, which had been cleaned by a cleaning process, by a dip coating method. The first coating composition was prepared by mixing urethane acrylate and a photoinitiator with a mixed organic solvent including methanol, methyl ethyl ketone (MEK), and isopropyl alcohol.

In the present example, the polycarbonate substrate coated with the first coating composition was heat-treated at about 60°C for about 3 minutes to volatilize the solvent included in the first coating composition. Thereafter, the urethane acrylate of the first coating composition was photocured by irradiation of ultraviolet light having a central wavelength of about 365 nm to form a first organic layer and a second organic layer. Each of the first organic layer and the second organic layer finally formed after the ultraviolet curing had a thickness of about 10 $\mu$m.

Next, in the present example, a second coating composition was provided on the first organic layer and the second organic layer by a dip coating method. The second coating composition included propylene glycol monomethyl ether acetate as a solvent, and included urethane acrylate, $SiO_2$ particles, and polydimethylsiloxane. Also, the second coating composition further included a photoinitiator. The second coating composition was coated, and the plastic substrate was then heat-treated at about 60°C for about 3 minutes to volatilize the solvent. Thereafter, a first organic-inorganic composite layer and a second organic-inorganic composite layer were formed by irradiation of ultraviolet light having a central wavelength of about 365 nm. In this example, each of the first organic-inorganic composite layer and the second organic-inorganic composite layer had a thickness of about 15 $\mu$m.

The first organic-inorganic composite layer was coated with a primer material. The primer material included a silane coupling agent and isocyanate. A heat treatment was performed at about 60°C for about 10 minutes after the coating with the primer material. A primer layer formed after the thermal curing had a thickness of about 20 nm.

An anti-finger coating layer was formed on the primer layer. A coating material including perfluoropolyether was provided by a spray coating method, and was thermally cured at about 60°C for about 60 minutes to form the anti-finger coating layer. The formed anti-finger coating layer had a thickness of about 50 nm.

A cover window according to an example, which included polycarbonate as a plastic substrate, and had a double-layer structured hard coating layer on both sides of the plastic substrate, was manufactured by the above-described manufacturing method. The cover window had the anti-finger coating layer on one side thereof. Also, bond strength between the anti-finger coating layer and the hard coating layer was improved by including the primer layer between the anti-finger coating layer and the hard coating layer.

**Evaluation of the Cover Window of the Example**

Scratch resistance of the surface of the cover window was evaluated for the cover window manufactured by the above-described manufacturing method. The scratch resistance was evaluated by measuring abrasion resistance to vibration. An abrasion test was performed using a vibration abrasion tester by RÖSLER® (ROSLER is a registered trademark Oberflachentechnik GmbH CORPORATION FED REP GERMANY).

The abrasion resistance was evaluated by measuring a color difference value of the cover window before and after the abrasion test, with a smaller color difference value indicating better scratch resistance. In the evaluation results, the expression "Performance (%) versus Glass" denotes relative physical property values of examples when performance of a glass substrate was defined as 100. That is, when a color difference value of the glass substrate after the vibration abrasion test was defined as 100, a ratio of the color difference value of the cover window to the color difference value of the glass substrate was represented as "Performance (%) versus Glass."

1. Evaluation of Scratch Resistance of the Cover Window of the Embodiment

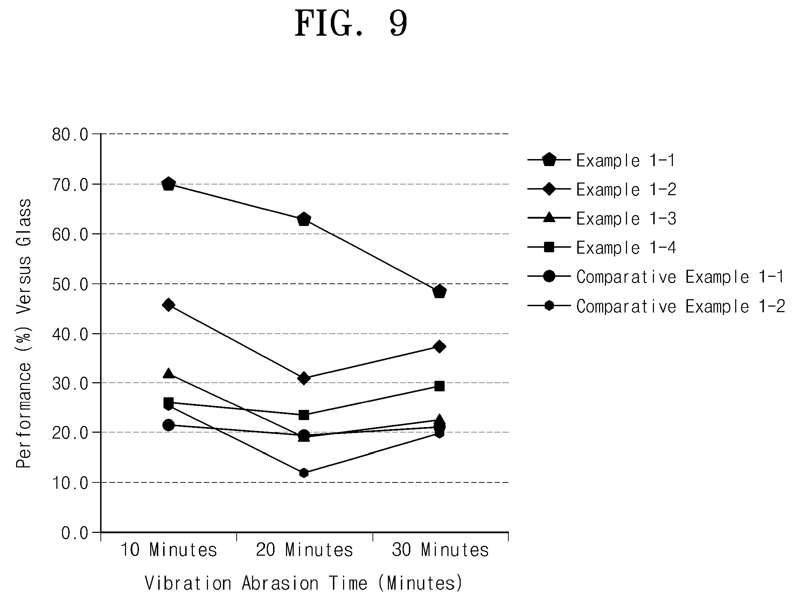

Table 1 illustrates configurations of Examples and Comparative Examples of a graph illustrated in FIG. 9. In the Examples and Comparative Examples, cover windows were configured to include a hard coating layer having two layers, a primer layer, and a functional layer. In the following Table 1, an organic layer represents the first organic layer or the second organic layer in the cover window, and an organic-inorganic composite layer represents the first organic-inorganic composite layer or the second organic-inorganic composite layer, according to an embodiment of the inventive concept.

The cover windows of Examples 1-1 to 1-4 were manufactured by the above-described method of manufacturing a cover window. However, with respect to the organic layer, Example 1-1 was composed of an organic layer including urethane acrylate, and Examples 1-2 to 1-4 were manufactured by modifying the organic layer to include acrylate/$SiO_2$/polydimethylsiloxane (PDMS).

Examples 1-2 to 1-4 were manufactured by changing a mixing ratio of urethane acrylate to $SiO_2$ in the organic-inorganic composite layer. With respect to Comparative Example 1-1, only a thickness of the functional layer was changed in comparison to Example 1-1, while other conditions were the same. The thickness of the functional layer in Example 1-1 was about 20 nm, and the thickness of the functional layer in Comparative Example 1-1 was about 10 nm. With respect to Comparative Example 1-2, other conditions were the same as those of Example 1-1, although constituent materials of the functional layer were changed. In Comparative Example 1-2, the functional layer was formed to include $Al_2O_3$.

Table 1

| Category | Organic layer | Organic-inorganic composite layer | Primer layer | Functional layer |
|---|---|---|---|---|
| Example 1-1 | Urethane acrylate | Urethane acrylate (60 wt%)/ $SiO_2$ (40 wt%)/ PDMS | Silane coupling agent | Perfluoropolyether |
| Example 1-2 | Acrylate (40 wt%) /$SiO_2$ (60 wt%) /PDMS | Urethane acrylate (80 wt%)/ $SiO_2$ (20 wt%)/ PDMS | Silane coupling agent | Perfluoropolyether |
| Example 1-3 | Acrylate (40 wt%) /$SiO_2$ (60 wt%) /PDMS | Urethane acrylate (70 wt%)/ $SiO_2$ (30 wt%)/ PDMS | Silane coupling agent | Perfluoropolyether |
| Example 1-4 | Acrylate (40 wt%) /$SiO_2$ (60 wt%) /PDMS | Urethane acrylate (60 wt%)/ $SiO_2$ (40 wt%)/ PDMS | Silane coupling agent | Perfluoropolyether |
| Comparative Example 1-1 | Urethane acrylate | Urethane acrylate (60 wt%)/ $SiO_2$ (40 wt%)/ PDMS | Silane coupling agent | Perfluoropolyether |
| Comparative Example 1-2 | Urethane acrylate | Urethane acrylate (60 wt%)/ $SiO_2$ (40 wt%)/ PDMS | Silane coupling agent | $Al_2O_3$ |

Referring to FIG. 9, Example 1-1 had the best scratch resistance regardless of the vibration abrasion test time elapsed. In particular, about 70% of the scratch resistance of a cover window using glass was observed during a vibration abrasion test time of about 10 minutes. That is, it may be understood that when the organic layer was formed to include urethane acrylate, as in Example 1-1, better scratch resistance was observed than when acrylate/SiO$_2$/PDMS were included in the organic layer, as in Examples 1-2 to 1-4.

Also, when the results of Example 1-1 and Comparative Example 1-1 were compared, the scratch resistance of Comparative Example 1-1, which had a thickness of the functional layer of less than about 20 nm, was reduced even when Example 1-1 and Comparative Example 1-1 had the same configuration of the hard coating layer.

When Example 1-1 and Comparative Example 1-2 were compared, better scratch resistance was observed when perfluoropolyether was included as the functional layer.

Thus, it may be understood that the cover window had excellent scratch resistance when the hard coating layer had a double layer structure of organic layer/organic-inorganic composite layer, and when the functional layer including perfluoropolyether was formed on the organic-inorganic composite layer to a thickness of about 20 nm or more, as in Example 1-1.

Also, with respect to the structure of the hard coating layer composed of two layers, improved scratch resistance was obtained in the cover window example having a structure including urethane acrylate as the organic layer.

Table 2 illustrates evaluation results of physical properties of cover windows according to changes in the thickness of the organic layer of the hard coating layer in an embodiment of the inventive concept. Structures of the cover windows of Examples 1-1A to 1-1D were the same as the above-described configuration of Example 1-1 of Table 1 with the exception of only the thickness of the organic layer being changed to evaluate the physical properties.

In Table 2, YI denotes "Yellow Index", which corresponds to evaluation of a change in yellowness among optical properties of the cover window. Because a higher Yellow Index (YI) corresponds to an increase in yellowish state, it also corresponds to deterioration in optical properties.

Table 2

| Category | Organic layer thickness ($\mu$m) | Layer adhesion | Reflectance (%) | Transmittance (%) | YI | Pencil hardness (H) |
|---|---|---|---|---|---|---|
| Example 1-1A | 10 | 96 | 8.2 | 91.6 | 0.9 | 6-7 |
| Example 1-1B | 15 | 93 | 7.9 | 91.6 | 1.0 | 7 |
| Example 1-1C | 20 | 62 | 7.9 | 91.6 | 1.1 | 7-8 |
| Example 1-1D | 25 | 26 | 7.8 | 90.5 | 2.5 | 8 |

With respect to certain optical properties, such as reflectance and transmittance, similar values were obtained regardless of changes in the thickness of the organic layer. However, layer adhesion and yellow index (YI) were deteriorated as the thickness of the organic layer was increased. Accordingly, good physical property values were observed when the organic layer in the hard coating layer was formed to a thickness of about 10 $\mu$m to about 20 $\mu$m.

2. Evaluation of Scratch Resistance of the Cover Window of the Embodiment according to PDMS Content of Organic-Inorganic Composite Layer

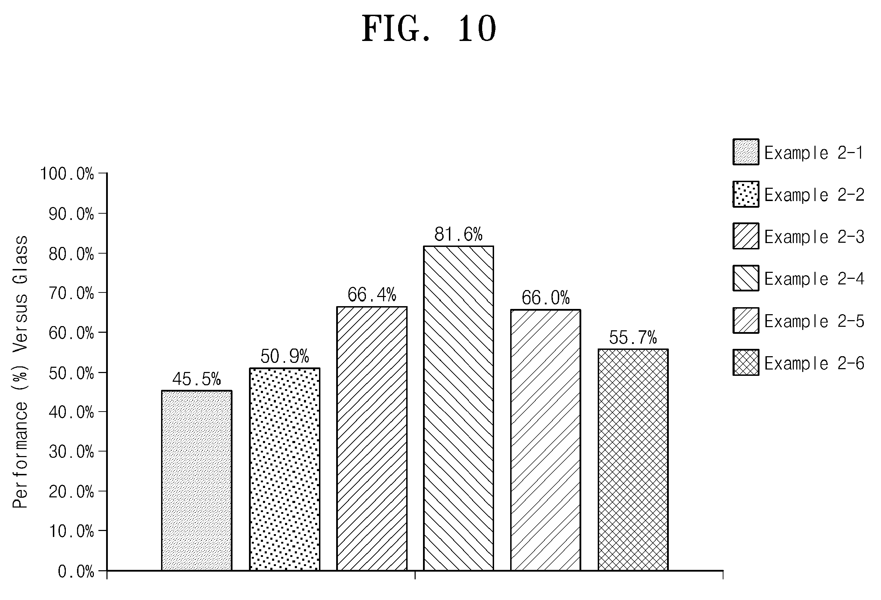

Table 3 illustrates configurations of the organic-inorganic composite layer in Examples illustrated in a graph of FIG. 10. A "solid content" represents a ratio of the solid to the solvent in the second coating composition forming the organic-inorganic composite layer. In an embodiment of the inventive concept, the solid content includes urethane acrylate/SiO$_2$/PDMS. A "PDMS content" represents a weight ratio of the PDMS with a total weight of the urethane acrylate and SiO$_2$ being defined as 100.

Table 3

| Category | Solid content (wt%) | PDMS content (wt%) |
|---|---|---|
| Example 2-1 | 70 | 0.18 |

(continued)

| Category | Solid content (wt%) | PDMS content (wt%) |
|---|---|---|
| Example 2-2 | 70 | 0.40 |
| Example 2-3 | 64 | 0.18 |
| Example 2-4 | 64 | 0.40 |
| Example 2-5 | 60 | 0.18 |
| Example 2-6 | 60 | 0.40 |

Referring to the results of FIG. 10, Examples 2-3 and 2-4, in which the solid content was about 64%, exhibited relatively good scratch resistance in comparison to a case in which the solid content was about 60% or about 70% at the same PDMS content. Also, when Example 2-3 and Example 2-4, which had the same solid content of about 64%, were compared to each other, when the PDMS content was about 0.40 wt% (Example 2-4), better scratch resistance was observed than when the PDMS content was about 0.18 wt% (Example 2-3).

Examples 2-5 and 2-6, in which the solid content was about 60%, had better scratch resistance than Examples 2-1 and 2-2, in which the solid content was about 70%.

Thus, in an embodiment of the inventive concept, it may be understood that the second coating composition forming the organic-inorganic composite layer formed a hard coating layer having relatively good scratch resistance in a solid content range of about 60% to about 70%.

3. Evaluation of Physical Properties of Cover Window According to Coating Method of Functional Layer

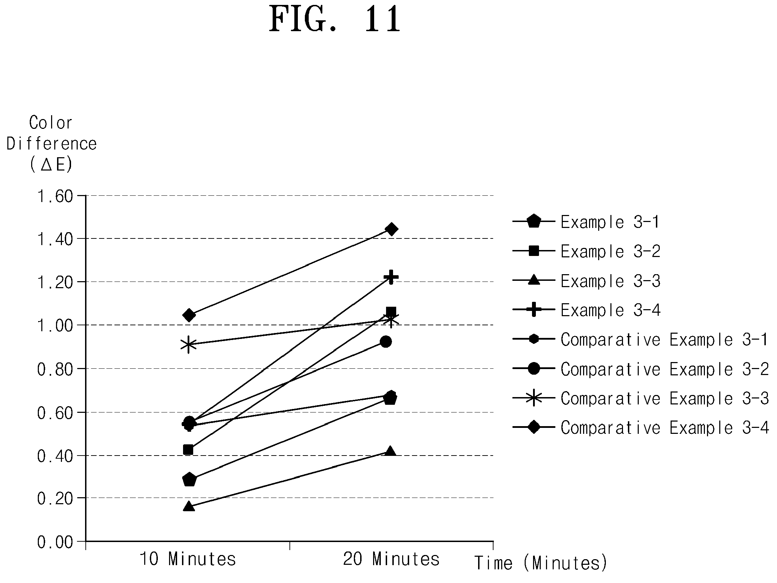

Table 4 illustrates evaluation results of scratch resistance and configurations of Examples and Comparative Examples illustrated in a graph of FIG. 11. Functional layers of the Examples were formed by a wet coating method, and functional layers of the Comparative Examples were formed by a dry coating method.

In Examples 3-1 to 3-4, an anti-finger coating layer, as the functional layer, was formed to a thickness of about 50 nm. A primer layer was formed to a thickness of about 10 nm or about 20 nm. With respect to Examples 3-1 and 3-2, a hard coating layer was composed of a single layer, and, with respect to Examples 3-3 and 3-4, a hard coating layer was composed of two layers. In Examples 3-1 and 3-2, the hard coating layer included only an organic-inorganic composite layer. In Examples 3-3 and 3-4, the hard coating layer included a double layer structure of organic layer/organic-inorganic composite layer.

In Comparative Examples 3-1 to 3-4, the functional layer was formed to a thickness of about 20 nm, and a primer layer was formed to a thickness of about 10 nm.

Scratch resistance of cover windows was evaluated as a color difference (ΔE) value before and after the vibration abrasion test. The color difference (ΔE) was calculated by the following equation.

$$\Delta E_{ab} = [(\Delta L^*)^2 + (\Delta a^*)^2 + (\Delta b^*)^2]^{1/2}$$

where the color difference (ΔE) denotes a difference between two points in a color coordinate system of L*a*b*.

Table 4

| Category | Functional layer thickness (nm) | Primer layer thickness (nm) | ΔE | | Performance (%) vs. Glass | |
|---|---|---|---|---|---|---|
| | | | 10 minutes | 20 minutes | 10 minutes | 20 minutes |
| Example 3-1 | 50 | 10 | 0.28 | 0.67 | 88.9 | 53.6 |
| Example 3-2 | 50 | 20 | 0.42 | 1.06 | 59.8 | 33.9 |
| Example 3-3 | 50 | 10 | 0.16 | 0.42 | 177.5 | 42.1 |
| Example 3-4 | 50 | 20 | 0.53 | 1.22 | 54.1 | 24.8 |
| Comparative Example 3-1 | 20 | 10 | 0.53 | 0.67 | 47.4 | 53.2 |

(continued)

| Category | Functional layer thickness (nm) | Primer layer thickness (nm) | ΔE | | Performance (%) vs. Glass | |
|---|---|---|---|---|---|---|
| | | | 10 minutes | 20 minutes | 10 minutes | 20 minutes |
| Comparative Example 3-2 | 20 | 10 | 0.55 | 0.93 | 45.8 | 38.5 |
| Comparative Example 3-3 | 20 | 10 | 0.91 | 1.03 | 31.6 | 29.4 |
| Comparative Example 3-4 | 20 | 10 | 1.05 | 1.44 | 27.5 | 21.0 |

Referring to the results of Table 4 and FIG. 11, it was observed that color difference values of Examples 3-1 to 3-4 using the wet coating method were smaller than those of Comparative Examples 3-1 to 3-4 using the dry coating method. That is, when the functional layer was formed by using the wet coating method, because the functional layer may be formed to a greater thickness than when the functional layer was formed by using the dry coating method, reliability of the functional layer may be improved. Also, when the functional layer was formed by using the wet coating method, because chemical bonding between the hard coating layer and the functional layer may be induced, adhesive strength of the functional layer to the hard coating layer may be improved.

Table 5 illustrates evaluation results of physical properties of cover windows according to a coating method of the functional layer in an embodiment of the inventive concept. A spray coating method was used as the wet coating method, and an e-beam coating method was used as the dry coating method.

The above-described manufacturing method was used as a method of manufacturing the cover windows, and manufacturing conditions other than the coating method were the same.

Abrasion resistance of the cover widow among evaluation items of Table 5 was evaluated by an abrasion test using an eraser. An industrial eraser used in the abrasion resistance evaluation was reciprocated and rubbed about 1,500 times on a surface of the cover window for the evaluation, and a reciprocating speed was about 40 rpm, and the test was performed under a load of about 500 g. After the eraser abrasion test, water ($H_2O$) was dropped on the surface of the cover window to measure a contact angle.

Chemical resistance of the cover window was evaluated using methyl alcohol (about 99.3% purity). The methyl alcohol was dropped on the surface of the cover window, and an eraser abrasion test was then performed. The number of reciprocations was about 250, the reciprocating speed was about 40 rpm, and the test was performed under a load of about 500 g. Thereafter, water ($H_2O$) was dropped on the surface of the cover window to measure a contact angle.

The abrasion resistance and the chemical resistance were evaluated by the degrees of change in contact angles of water ($H_2O$) to the surface of the cover window as measured before and after the eraser abrasion test. That is, an initial contact angle of the water ($H_2O$) before the eraser abrasion test, and a contact angle of the water ($H_2O$) after the eraser abrasion test, were measured and compared.

Referring to Table 5, because surface energy was reduced when the wet coating method as a coating condition of the functional layer was used under the same conditions, a friction coefficient of the surface of the cover window was reduced. Thus, it may be understood that the scratch resistance of the cover window was improved when the functional layer was formed by the wet coating method. Also, from the reliability results of abrasion resistance and chemical resistance, it may be confirmed that a case of wet coating had smaller changes in the surface contact angle than a case of dry coating. Thus, it may be understood that the cover window formed by the wet coating method had better reliability than the cover window formed by the dry coating method.

Table 5

| Category | Surface energy (mN/m) | Friction coefficient | Haze (%) | Initial contact angle (°) | Abrasion resistance (°) | Chemical resistance (°) |
|---|---|---|---|---|---|---|
| Wet coating | 14.83 | 0.067 | 0.18 | 119.2 | 116.8 | 113.0 |
| Dry coating | 15.11 | 0.127 | 0.17 | 118.3 | 104.9 | 105.8 |

4. Evaluation of Scratch Resistance of the Cover Window of the Embodiment According to Configuration of Primer Layer

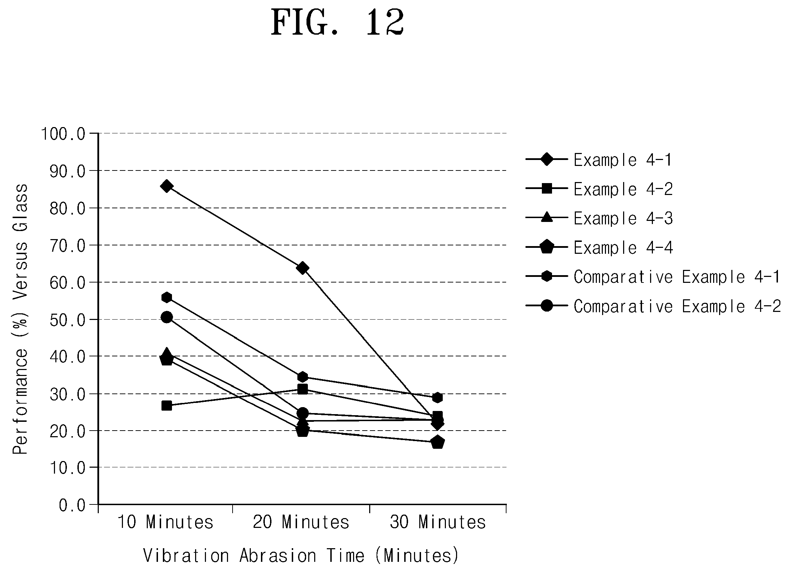

Table 6 illustrates configurations of Examples and Comparative Examples illustrated in a graph of FIG. 12. Examples 4-1 to 4-4 were configured to include a silane coupling agent and isocyanate in primer layers. In Examples 4-1 to 4-4, amounts of the isocyanate included in the primer layers were different from one another. In this case, the amount of the isocyanate corresponds to a weight ratio of the isocyanate to a total weight of the primer material constituting the primer layer.

In Comparative Example 4-1, silicon oil, instead of the primer layer, was used between the first organic-inorganic composite layer and the functional layer. In Comparative Example 4-2, an acetic acid catalyst was used instead of the primer layer.

Table 6

| Category | Configuration of primer layer |
| --- | --- |
| Example 4-1 | Silane coupling agent / isocyanate (100%) |
| Example 4-2 | Silane coupling agent / isocyanate (80%) |
| Example 4-3 | Silane coupling agent / isocyanate (50%) |
| Example 4-4 | Silane coupling agent / isocyanate (20%) |
| Comparative Example 4-1 | Silicon oil |
| Comparative Example 4-2 | Acetic acid ($CH_3COOH$) catalyst |

Referring to the graph of FIG. 12, under a vibration abrasion test condition of 10 minutes, Example 4-1 exhibited about 85% or more of the scratch resistance characteristics of the cover window using the glass substrate. When the evaluation results of Examples 4-1 to 4-4 were compared, it was observed that the scratch resistance obtained when the isocyanate was included in an amount of about 100% was improved when compared to the comparative examples. With respect to Examples 4-2 to 4-4, in which the amount of the isocyanate was smaller than that of Example 4-1, it was observed that improvement in scratch resistance was relatively small. That is, when the amount of the isocyanate included in the primer layer was less than about 100%, Examples 4-2 to 4-4 had a similar level of scratch resistance in comparison to Comparative Examples 4-1 or 4-2, in which the primer layer was not used.

The cover window according to the embodiment of the inventive concept, and the display device, may prevent the distortion of the cover window, or may prevent peeling-off phenomenon under reliability conditions by symmetrically including the hard coating layer on both sides relative to the plastic substrate. Also, because the hard coating layer is composed of two layers of the organic layer and the organic-inorganic composite layer, high hardness and high scratch resistance may be obtained.

In the cover window according to the embodiment of the inventive concept, because the organic layer is configured to include urethane acrylate to perform a shock-absorbing function in the hard coating layer, a breakage phenomenon of the hard coating layer may be reduced. Also, the slip of the hard coating layer may be improved by including polydimethylsiloxane in the organic-inorganic composite layer, and thus, the scratch resistance may be improved.

Furthermore, a cover window having higher surface hardness and scratch resistance than those of a typical cover window of a plastic material, as well as high hardness, may be provided by using the method of manufacturing a cover window according to the embodiment of the inventive concept.

A cover window according to an embodiment of the inventive concept may have improved scratch resistance by disposing a double-layer structured hard coating layer including an organic layer and an organic-inorganic composite layer on a plastic substrate.

Also, a display device according to an embodiment of the inventive concept may improve surface qualities of the display device by including a cover window including an organic layer and an organic-inorganic composite layer.

Furthermore, a method of manufacturing a cover window according to an embodiment of the inventive concept may provide a cover window having excellent scratch resistance by forming a double-layer structured hard coating layer on both sides of a plastic substrate.

Although exemplary embodiments of the present invention have been described, it is understood that the present invention should not be limited to these exemplary embodiments, and that various changes and modifications can be made by one of ordinary skill in the art within the scope of the present invention as hereinafter claimed.

Accordingly, the invention is not limited by the foregoing description, but is only limited by the scope of the claims appended thereto, and the functional equivalents of the claims.

**Claims**

1. A cover window (CW, CW-1, CW-2) comprising:

   a plastic substrate (SUB);
   a first hard coating layer (HC-1) on a first surface of the plastic substrate (SUB), the first hard coating layer (HC-1) comprising:

      a first organic-inorganic composite layer (IL-1) on the first surface; and
      a first organic layer (OL-1) between the first surface and the first organic-inorganic composite layer (IL-1);

   a second hard coating layer (HC-2) on a second surface of the plastic substrate (SUB) opposite to the first surface, the second hard coating layer (HC-2) comprising:

      a second organic-inorganic composite layer (IL-2) on the second surface; and
      a second organic layer (OL-2) between the second surface and the second organic-inorganic composite layer (IL-2); and

   a functional layer (AFL) on the first hard coating layer (HC-1).

2. The cover window of claim 1, wherein the first organic layer (OL-1) and the second organic layer (OL-2) comprise urethane acrylate.

3. The cover window of one of the preceding claims, wherein the first organic-inorganic composite layer (IL-1) and the second organic-inorganic composite layer (IL-2) comprise:

   an acrylate-based compound;
   inorganic particles dispersed in the acrylate-based compound; and
   polydimethylsiloxane (PDMS).

4. The cover window of claim 3, wherein the inorganic particles comprise at least one selected of silicon oxide, zirconium oxide, aluminum oxide, tantalum oxide, niobium oxide, or glass beads.

5. The cover window of one of the preceding claims, wherein the functional layer (AFL) comprises perfluoropolyether.

6. The cover window of one of the preceding claims, further comprising a primer layer (PL) between the first organic-inorganic composite layer (IL-1) and the functional layer (AFL).

7. The cover window of claim 6, wherein the primer layer (PL) includes a silane coupling agent and isocyanate.

8. A display device (DD) comprising:

   a display module (DM);
   a housing (HUS) accommodating the display module (DM); and
   a cover window according to one of claims 1 through 7 on the display module (DM).

9. A method of manufacturing a cover window (CW, CW-1, CW-2), the method comprising:

   forming a first organic layer (OL-1) on a first surface of a plastic substrate (SUB);
   forming a second organic layer (OL-2) on a second surface of the plastic substrate (SUB) opposite to the first surface;
   forming a first organic-inorganic composite layer (IL-1) on the first organic layer (OL-1);
   forming a second organic-inorganic composite layer (IL-2) on the second organic layer (OL-2); and
   forming a functional layer (AFL) on the first organic-inorganic composite layer (IL-1).

10. The method of claim 9, wherein the first organic layer (OL-1) and the second organic layer (OL-2) comprise urethane acrylate.

11. The method of one of claims 9 and 10, wherein the forming of the first organic layer (OL-1) and the forming of the second organic layer (OL-2) are performed during a same process.

12. The method of claim 11, wherein the forming of the first organic layer (OL-1) and the forming of the second organic layer (OL-2) comprise:

   providing a first coating composition on the plastic substrate (SUB),
   performing a heat treatment on the first coating composition, and
   ultraviolet curing the first coating composition.

13. The method of one of claims 9 to 12, wherein the forming of the first organic-inorganic composite layer (IL-1) and the forming of the second organic-inorganic composite layer (IL-2) comprise:

   providing a second coating composition on the first organic layer (OL-1) and the second organic layer (OL-2);
   performing a heat treatment on the second coating composition; and
   ultraviolet curing the second coating composition.

14. The method of claim 13, wherein the second coating composition comprises an acrylate-based compound, inorganic particles, and polydimethylsiloxane (PDMS), and
   wherein a weight ratio of the acrylate-based compound to the inorganic particles is in a range of 5:5 to 8:2.

15. The method of claim 14, wherein the second coating composition comprises comprises an amount of polydimethylsiloxane (PDMS) ranging from 0.2 wt% to 0.6 wt% based on a total weight of the acrylate-based compound and the inorganic particles.

# FIG. 1

# FIG. 2

DD

SA2 | FA | SA1

CW  DM  HUS

I

I'

DR3

DR5  DR4

DR1

# FIG. 3

DD

SA-W2

FA-W

SA-W1

II

II'

CW

NDA-D

DM

DA-S2

DA-F

DA-D

DA-S1

SA-H2

FA-H

SA-H1

HUS

DR3

DR2

DR4

DR1

# FIG. 4

OCA

OCA

OCA

LF

TSU

DP

PF

DR3

DR1

# FIG. 5

CW-1

AFL

PL

IL-1

OL-1

} HC-1

SUB

OL-2

IL-2

} HC-2

DR3

DR1

# FIG. 6

EP 3 173 856 A1

# FIG. 7

```
                        ┌──────────┐
                        │  Start   │
                        └────┬─────┘
                             │
            ┌────────────────┴────────────────┐
            │                                 │
            ▼  ~S110                          ▼  ~S210
  ┌──────────────────────┐        ┌──────────────────────┐
  │  Form first organic  │        │  Form second organic │
  │  layer on plastic    │        │  layer on plastic    │
  │  substrate           │        │  substrate           │
  └──────────┬───────────┘        └──────────┬───────────┘
             │  ~S130                         │  ~S230
             ▼                                ▼
  ┌──────────────────────┐        ┌──────────────────────┐
  │  Form first organic- │        │  Form second organic-│
  │  inorganic composite │        │  inorganic composite │
  │  layer               │        │  layer               │
  └──────────┬───────────┘        └──────────┬───────────┘
             │                                │
             └────────────────┬───────────────┘
                              ▼
                  ┌──────────────────────┐
                  │  Form primer layer   │ ~S300
                  └──────────┬───────────┘
                             ▼
                  ┌──────────────────────┐
                  │  Form functional layer│ ~S400
                  └──────────┬───────────┘
                             ▼
                        ┌──────────┐
                        │   End    │
                        └──────────┘
```

# FIG. 8A

# FIG. 8B

# FIG. 9

EP 3 173 856 A1

# FIG. 10

FIG. 11

EP 3 173 856 A1

# FIG. 12

Europäisches
Patentamt

European
Patent Office

Office européen
des brevets

# EUROPEAN SEARCH REPORT

**Application Number**

EP 16 18 6119

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/177748 A1 (HIRAI AKIRA [KR] ET AL) 11 July 2013 (2013-07-11) | 1,2,5-13 | INV. G02F1/1333 B32B27/08 G02B1/14 |
| Y | * paragraph [0048] - paragraph [0065]; figure 2 * ----- | 3,4,14, 15 | |
| Y | WO 2012/026245 A1 (KONICA MINOLTA OPTO INC [JP]; OKANO SATOSHI [JP]) 1 March 2012 (2012-03-01) * paragraph [0291] * ----- | 3,4,14, 15 | |

**TECHNICAL FIELDS SEARCHED (IPC)**

G02F
B32B

The present search report has been drawn up for all claims

| Place of search | Date of completion of the search | Examiner |
|---|---|---|
| Munich | 31 January 2017 | Frank, Wolfgang |

EPO FORM 1503 03.82 (P04C01)

## ANNEX TO THE EUROPEAN SEARCH REPORT
## ON EUROPEAN PATENT APPLICATION NO.

EP 16 18 6119

This annex lists the patent family members relating to the patent documents cited in the above-mentioned European search report.
The members are as contained in the European Patent Office EDP file on
The European Patent Office is in no way liable for these particulars which are merely given for the purpose of information.

31-01-2017

| Patent document cited in search report | | Publication date | Patent family member(s) | | Publication date |
|---|---|---|---|---|---|
| US 2013177748 | A1 | 11-07-2013 | CN | 103192558 A | 10-07-2013 |
| | | | JP | 2013143130 A | 22-07-2013 |
| | | | KR | 20130081576 A | 17-07-2013 |
| | | | TW | 201334976 A | 01-09-2013 |
| | | | US | 2013177748 A1 | 11-07-2013 |
| WO 2012026245 | A1 | 01-03-2012 | JP | 5633566 B2 | 03-12-2014 |
| | | | KR | 20130069736 A | 26-06-2013 |
| | | | WO | 2012026245 A1 | 01-03-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020150168994